# EUROPÄISCHE PATENTSCHRIFT

(11) **EP 3 403 103 B1**
(45) Veröffentlichungstag und Bekanntmachung des Hinweises auf die Patenterteilung: **22.11.2023**
(21) Anmeldenummer: 16819272.2
(22) Anmeldetag: 06.12.2016
(51) Int. Cl.: G01R 1/067, G01R 1/073, G01R 3/00

(54) **VERFAHREN ZUR PLATZIERUNG UND KONTAKTIERUNG EINES PRÜFKONTAKTS**
METHOD FOR PLACING AND MAKING CONTACT WITH A TEST CONTACT
PROCÉDÉ DE PLACEMENT ET DE MISE EN CONTACT ÉLECTRIQUE D'UN CONTACT DE TEST

(30) Priorität: 14.01.2016 DE 102016100561
(43) Veröffentlichungstag der Anmeldung: 21.11.2018
(73) Patentinhaber: Pac Tech - Packaging Technologies GmbH, 14641 Nauen (DE)
(72) Erfinder: KRAUSE, Thorsten, 16727 Velten (DE)
(74) Vertreter: advotec.
(86) Internationale Anmeldenummer: PCT/EP2016/079872
(87) Internationale Veröffentlichungsnummer: WO 2017/121542

(56) Entgegenhaltungen:
- EP-A1- 0 430 861
- WO-A1-2009/156505
- WO-A1-2017/032532
- DE-A1- 19 504 967
- DE-A1- 19 602 591
- DE-A1-102008 051 853
- DE-A1-102010 039 238
- JP-A- H05 337 662
- JP-A- 2000 218 383
- JP-A- 2008 232 722
- US-A- 4 970 365
- US-A1- 2003 085 721
- US-B1- 6 313 653
- YUFEI LIU ET AL: "Temperature monitoring in laser assisted polymer bonding for MEMS packaging using a thin film sensor array", SENSORS APPLICATIONS SYMPOSIUM, 2009. SAS 2009. IEEE, IEEE, PISCATAWAY, NJ, USA, 17. Februar 2009 (2009-02-17), Seiten 52-55, XP031437558, ISBN: 978-1-4244-2786-4
- BURKE BRIAN G ET AL: "Laser heating and detection of bilayer microcantilevers for non-contact thermodynamic measurements", APPLIED PHYSICS LETTERS, A I P PUBLISHING LLC, US, Bd. 102, Nr. 2, 14. Januar 2013 (2013-01-14), Seiten 21916-21916, XP012168801, ISSN: 0003-6951, DOI: 10.1063/1.4776197 [gefunden am 2013-01-18]
- PACARDO DENNIS B ET AL: "A temperature microsensor for measuring laser-induced heating in gold nanorods", ANALYTICAL AND BIOANALYTICAL CHEMISTRY, SPRINGER, DE, Bd. 407, Nr. 3, 11. Oktober 2014 (2014-10-11), Seiten 719-725, XP035434135, ISSN: 1618-2642, DOI: 10.1007/S00216-014-8222-9 [gefunden am 2014-10-11]

## Beschreibung

Die vorliegende Erfindung betrifft ein Verfahren zur Platzierung und Kontaktierung eines insbesondere als Prüfkontakt einer Prüfkontaktanordnung ausgebildeten Kontaktelements, bei dem ein mit einer Kontaktelementhalteeinrichtung versehener Kontaktkopf mit dem in der Kontaktelementhalteeinrichtung aufgenommenen Kontaktelement zur Ausbildung einer Wärmeübergangsfläche zwischen dem Kontaktelement und einem auf einer Kontaktfläche eines Kontaktträgers angeordneten Verbindungsmaterialdepot in Richtung einer Zustellachse gegen eine Kontaktoberfläche des Verbindungsmaterialdepots platziert wird, und zur Erzielung eines zumindest partiellen Aufschmelzens des Verbindungsmaterialdepots und zur Herstellung einer stoffschlüssigen Verbindung zwischen dem Kontaktelement und dem Verbindungsmaterialdepot die Einbringung von Wärmeenergie in das Verbindungsmaterialdepot mittels einer Beaufschlagung des Kontaktelements mit Wärmeenergie erfolgt.

Prüfkontaktanordnungen mit einer Vielzahl von Prüfkontakten sind auf einer gemeinsamen Prüfplattform angeordnet, die mit einer Ansteuereinrichtung zur Ansteuerung der einzelnen Prüfkontakte versehen ist. Die Prüfkontakte befinden sich dabei in einer Matrixanordnung entsprechend den in einem Waferverbund angeordneten Chips, so dass über die einzelnen Prüfkontakte eine definierte Kontaktierung der einzelnen Chips auf Waferebene möglich ist.

Zur Herstellung einer Prüfkontaktanordnung werden die einzelnen Prüfkontakte entsprechend der gewünschten Matrixanordnung ihrer Kontaktspitzen auf einem als Prüfplatine ausgebildeten Kontaktträger angeordnet und mit auf der Prüfplatine ausgebildeten Kontaktflächen verlötet. Aufgrund der hohen Dichte der Prüfkontakte auf jeder Prüfplatine und dem sich daraus ergebenden geringen Abstand der Prüfkontakte voneinander bestehen besonders hohe Anforderungen an eine sowohl elektrisch zuverlässige als auch positionsgenaue Kontaktierung der Prüfkontakte auf der Platine.

Da sich die einzelnen in dem Waferverbund angeordneten Chips in einer gemeinsamen, durch die Oberfläche des Wafers definierten Waferebene befinden, ist es für eine Kontaktierung der einzelnen Chips, die mit einer einheitlichen Kontaktkraft erfolgen sollte, wesentlich, dass auch die Kontaktspitzen der in einer Matrixanordnung angeordneten Prüfkontakte sich in einer gemeinsamen Kontaktierungsebene befinden. Hierzu müssen die Kontaktspitzen der einzelnen Prüfkontakte in einem einheitlichen Kontaktabstand gegenüber dem Kontaktträger der Prüfplatine angeordnet sein. Daher erfolgt bei der Platzierung der Prüfkontakte auf den Kontaktflächen des Kontaktträgers nicht nur eine Positionierung der Prüfkontakte in einer X, Y-Ebene parallel zur Oberfläche des Kontaktträgers, sondern darüber hinaus auch eine Positionierung längs der Z-Achse senkrecht zur Oberfläche des Kontaktträgers, um einen übereinstimmenden Kontaktabstand der Kontaktspitzen gegenüber der Oberfläche des Kontaktträgers zu ermöglichen.

In der bisherigen Praxis erfolgt hierzu die Platzierung der Prüfkontakte gegen die Oberfläche des auf den Kontaktflächen des Kontaktträgers angeordneten Verbindungsmaterialdepots mit einer definierten Kontaktkraft und Aufheizung der Prüfkontakte über eine ausreichend lange Aufheizdauer, die sicherstellt, dass die Verbindungsmaterialdepots zumindest soweit aufschmelzen, dass die Prüfkontakte mit einem unteren Kontaktrand in den aufgeschmolzenen Verbindungsmaterialdepots eingebettet sind und anschließend über geeignete Stellbewegungen des Kontaktkopfs in Richtung der Z-Achse der gewünschte Kontaktabstand eingestellt werden kann. Anschließend werden die Prüfkontakte aus der Prüfkontakthalteeinrichtung des Kontaktkopfs freigegeben.

In der bisherigen Praxis wird bei der Platzierung und Kontaktierung der Prüfkontakte mit einer konstanten Aufheizdauer kontaktiert, die insbesondere in Abhängigkeit von der Materialzusammensetzung des Verbindungsmaterialdepots empirisch ermittelt wird. Dabei hat sich herausgestellt, dass insbesondere aufgrund der teilweise unterschiedlichen Morphologie der einzelnen Verbindungsmaterialdepots, die eine unterschiedliche Oberflächentopographie der Verbindungsmaterialdepots zur Folge hat, tatsächlich entsprechend unterschiedliche Aufheizzeiten erforderlich sind, um ein zumindest partielles Aufschmelzen der Verbindungsmaterialdepots zu erreichen, das sicherstellt, dass die Prüfkontakte mit ihrem unteren Kontaktrand in das Verbindungsmaterialdepot eingebettet und der gewünschte einheitliche Kontaktabstand eingestellt werden kann.

Aufgrund der in der Praxis konstant eingestellten Aufheizzeit kann es daher auftreten, dass es wegen eines unzureichenden Aufschmelzens eines Teils der Verbindungsmaterialdepots zu unterschiedlich hohen Kontaktabständen in ein und derselben Matrixanordnung von Prüfkontakten kommt.

Aus der JPH 05 337662 A ist ein Verfahren zur Bewertung der Schweißqualität bekannt, wobei ein Laserstrahl auf die Schweißnaht ausgerichtet wird und die zeitliche Änderung der Temperatur des mit dem Laserstrahl bestrahlten Schweißabschnitts ermittelt wird. Zur Bewertung der Schweißqualität wird nach Temperaturbeaufschlagung der Schweißnaht der Temperaturabfall an der Schweißnaht über die Zeit betrachtet und anhand dessen die Schweißnaht qualitativ beurteilt.

In der JP 2000 218383 A ist ein bekanntes Verfahren zum Laserschwei-ßen zweier Werkstücke beschrieben, wobei der Schweißprozess derart überwacht und gesteuert wird, dass er unter optimalen Temperaturbedingungen abläuft. Zur Steuerung und Überwachung des Schweißprozesses wird die Temperatur im Bereich der Schweißnaht erfasst.

Der EP 0 430 861 A1 ist ein Laserlötsystem für SMD (Surface-mounted device)-Elemente zur Einhaltung enger Temperatur-Zeit-Toleranzen während des Lötvorgangs zu entnehmen. Um eine möglichst wirtschaftliche Laserlötung mit dem Laserlötsystem durchführen, entsprechend kurze Laserlötzeiten realisieren und Überhitzungen vermeiden zu können, ist eine Temperatursteuerung sowie eine robotergesteuerte Justierung der Beabstandung der Laseroptik von der Lötstelle vorgesehen.

Die US 6,313,653 B1 offenbart eine Testvorrichtung zum Testen integrierter Halbleiterschaltungen elektronischer Geräte unter Vermeidung von Kondensation auf einer Leiterplatte. Hierzu wird bei Durchführung eines Tests die zu untersuchende Vorrichtung mittels zusätzlichen Heizelementen aufgeheizt und die Temperatur der Vorrichtung mittels eines Temperatursensors überwacht.

Aus der DE 195 04 967 A1 ist ein Verfahren zur thermischen Verbindung von Kontaktelementen eines flexiblen Substrats mit Kontakten eines elektronischen Bauelements bekannt, wobei die Energiebeaufschlagung der Kontaktelemente von deren Rückseite her mittels eines Lasers erfolgt. Um Schädigungen des Substrats zu verhindern, ist neben einer Temperaturbeaufschlagung auch eine Druckbeaufschlagung des Substrats vorgesehen, so dass eine ausreichende Wärmekopplung zwischen den Kontaktelementen und den Kontaktmetallisierungen gegeben ist und somit eine schädigende Temperaturbelastung ausgeschlossen werden kann.

Aus der US 2003/0085721 A1 sind ein Verfahren und eine Vorrichtung zur Kompensation der beim Testen von Chips in Prüfkarten induzierten thermischen Energie bekannt. Um eine Verformung der Prüfkarte und damit eine mögliche Beschädigung der zu testenden Kontaktanordnungen auszuschließen, ist es vorgesehen, die Temperatur auf beiden Seiten der Prüfkarte zu erfassen und anhand von Temperatursteuerelementen Wärme je nach Bedarf aufzubringen oder abzuführen.

Die wissenschaftliche Veröffentlichung "Temperature monitoring in laser assisted polymer bonding for MEMS packaging using a thin film sensor array" von Yufei Liu et al. vom 17.02.2009 beschreibt Möglichkeiten zur Temperaturüberwachung beim laserunterstützten Verbinden von Polymeren in der Mikrosystemtechnik, indem eine Dünnfilm-Sensormatrix verwendet wird.

Der Veröffentlichung "Laser heating and detection of bilayer microcantilevers for non-contact thermodynamic measurements" von Burke Brian G. et al. vom 14. Januar 2013 ist ein Verfahren zur kontrollierten und zudem extrem schnellen Aufheizung von Nanostrukturen mittels Laser zu entnehmen.

Aus der Veröffenltichung "A temperature microsensor for measuring Iaser-induced heating in gold nanorods" von Pacardo Dennis B et al., publiziert am 11. Oktober 2014, ist ein miniaturisierter Temperatursensor für Messungen an Mikrostrukturen, während diese mittels Laser erhitzt werden, bekannt.Aus der DE 10 2008 051 853 A1 ist ein Verfahren bekannt, bei dem eine Platzierung und Kontaktierung eines Kontaktelements erfolgt, derart, dass zur Erzielung eines zumindest partiellen Aufschmelzens eines Verbindungsmaterialdepots und zur Herstellung einer stoffschlüssigen Verbindung zwischen dem Kontaktelement und dem Verbindungsmaterialdepot die Einbringung von Wärmeenergie in das Verbindungsmaterialdepot mittels einer Beaufschlagung des Kontaktelements mit Wärmeenergie erfolgt.

Die WO 2009/156505 A1 offenbart ein Verfahren zur Herstellung einer Lotverbindung zwischen zwei Kontaktleitern, bei dem der obere Kontaktleiter mit im Wesentlichen konstanter Laserstrahlungsleistung bis zur Feststellung eines Temperaturanstiegs auf eine Solltemperatur beaufschlagt wird und nachfolgend zur Ausbildung einer Temperaturhaltephase eine Temperaturregelung erfolgt.

Der vorliegenden Erfindung liegt daher die Aufgabe zugrunde, ein Verfahren zur Platzierung und Kontaktierung eines Prüfkontakts vorzuschlagen, das die Einstellung eines definierten Kontaktabstands gegenüber einem Kontaktträger sicherstellt.

Zur Lösung dieser Aufgabe weist das erfindungsgemäße Verfahren die Merkmale des Anspruchs 1 auf.

Erfindungsgemäß wird während der Beaufschlagung des Kontaktelements mit Wärmeenergie die Temperatur des Kontaktelements gemessen und die Dauer der Beaufschlagung in Abhängigkeit von einem ermittelten Temperaturgradienten der Temperatur des Kontaktelements definiert.

Die Erfindung macht sich die Erkenntnis zu nutze, dass der Wärmeübergang von dem mit Wärmeenergie beaufschlagten Kontaktelement auf das Verbindungsmaterialdepot im Wesentlichen abhängig ist von der zwischen dem Kontaktelement und der Oberfläche des Verbindungsmaterialdepots ausgebildeten Wärmeübergangsfläche. Die Wärmeübergangsfläche ergibt sich dabei im Wesentlichen durch die Oberflächentopographie des Verbindungsmaterialdepots, die sich jedoch auch über die Aufheizdauer durch das fortschreitende partielle Aufschmelzen des Verbindungsmaterialdepots ändert. Dies hat direkte Auswirkungen auf den Temperaturgradienten der Temperatur des Kontaktelements, der sich aus dem Wärmeübergang vom Kontaktelement auf das Verbindungsmaterialdepot ergibt. Dies bedeutet, dass in einer Anfangsphase des zwischen dem Kontaktelement und dem Verbindungsmaterialdepot ausgebildeten Körperkontakts aufgrund einer stark zerklüfteten Oberflächentopographie des Verbindungsmaterialdepots eine relativ kleine Wärmeübergangsfläche und ein entsprechend geringer Temperaturgradient ausgebildet ist, da nur eine entsprechend geringe Wärmemenge vom Kontaktelement auf das Verbindungsmaterialdepot übertragen wird. In einer nachfolgenden Übergangsphase während des fortgesetzten Aufheizens des Kontaktelements ergibt sich wegen des fortschreitenden Aufschmelzens des Verbindungsmaterialdepots eine Einebnung der Oberflächentopographie mit entsprechender Vergrößerung der Wärmeübergangsfläche und einem sich daraus ergebenden vergrößerten Temperaturgradienten. In einer Endphase der Aufheizdauer ergibt sich schließlich aufgrund des fortschreitenden Aufschmelzens des Verbindungsmaterialdepots eine Einbettung des Kontaktrands des Kontaktelements in das Verbindungsmaterialdepot mit einer nochmaligen Erhöhung des Temperaturgradienten.

Das erfindungsgemäße Verfahren macht sich somit den Zusammenhang zwischen dem Verlauf des Temperaturgradienten der Temperatur des Kontaktelements und dem Schmelzzustand des Verbindungsmaterialdepots zu nutze. Damit kann die Aufheizdauer für jede einzelne Kontaktierung zwischen einem Kontaktelement und einem Verbindungsmaterialdepot individuell definiert werden, so dass sichergestellt ist, dass die Temperaturbeaufschlagung des Kontaktelements genau so lange erfolgt, wie es zum ausreichenden Aufschmelzen des Verbindungsmaterialdepots als Voraussetzung für die Einstellung eines definierten Kontaktabstands notwendig ist.

Abgesehen davon, dass hiermit Fehlkontaktierungen zwischen Kontaktelementen und Verbindungsmaterialdepots vermieden werden können, kann damit die Zeitdauer zum Aufheizen eines Kontaktelements auf ein Minimum reduziert werden, so dass die Herstellungszeit zur Herstellung einer Prüfkontaktanordnung mit einer Vielzahl von in Matrixanordnung auf einem Kontaktträger angeordneten als Prüfkontakte ausgeführten Kontaktelementen reduziert werden kann.

Wahlweise kann die Beaufschlagung des Kontakts mit Wärmeenergie in Abhängigkeit vom Betrag oder dem Verlauf des Temperaturgradienten erfolgen.

Wenn die Beaufschlagung des Kontaktelements mit Wärmeenergie mittels Laserstrahlung erfolgt, kann ein unmittelbarer Wärmeeintrag in das Kontaktelement erfolgen, der die Einstellung exakt definierter Aufheizverläufe für das Kontaktelement ermöglicht.

Besonders vorteilhaft ist es, wenn nach Erreichen eines definierten Temperaturgradienten und vor Beendigung der Beaufschlagung mit Wärmeenergie eine Änderung der Relativposition des Kontaktkopfs gegenüber dem Kontaktträger zur Einstellung einer definierten Relativposition des stoffschlüssig mit dem Verbindungsmaterialdepot verbundenen Kontaktelements auf dem Kontaktträger erfolgt.

Besonders vorteilhaft ist es, wenn zur Einstellung einer definierten Relativposition des Kontaktelements auf dem Kontaktträger eine Verstellung des Kontaktkopfs auf der Zustellachse erfolgt.

Vorzugsweise erfolgt nach erfolgter Positionierung und einer der Beendigung der Beaufschlagung des Kontaktelements mit Wärmeenergie nachfolgenden Abkühlphase des Kontaktelements eine Freigabe des Kontaktelements aus der Prüfkontakthalteeinrichtung.

Die Messung der Temperatur des Kontaktelements kann mittels der Messung der von einer Referenzoberfläche des Kontaktelements reflektierten Wärmestrahlung erfolgen, so dass eine berührungslose Temperaturmessung möglich ist.

Besonders vorteilhaft ist es, wenn die Referenzoberfläche mit einer Absorptionsoberfläche des Kontaktelements übereinstimmt, die mit Wärmeenergie beaufschlagt wird, so dass bei einer Temperaturbeaufschlagung des Kontaktelements mit Laserstrahlung ein und derselbe Strahlungskanal sowohl zur Temperaturbeaufschlagung als auch zur Temperaturmessung verwendbar ist.

Hierzu kann in besonders vorteilhafter Weise die Temperaturmessung mittels eines in einem Strahlengang zur Beaufschlagung der Absorptionsfläche mit Laserstrahlung angeordneten Strahlteilers erfolgen, durch den eine Auskopplung eines Infrarotstrahlenanteils aus der von der Absorptionsoberfläche reflektierten Strahlung zur Beaufschlagung einer Sensoreinrichtung erfolgt.

Gemäß einer möglichen Variante kann die Referenzoberfläche durch eine der Absorptionsoberfläche gegenüberliegende Oberfläche des Prüfkontakts gebildet sein, wobei dann in besonders vorteilhafter Weise die Temperaturmessung mittels eines auf die Referenzoberfläche ausgerichteten Strahlenkanals erfolgen kann, der auf eine Sensoreinrichtung ausgerichtet ist.

In einer bevorzugten Ausführungsform des Verfahrens erfolgt die Temperaturmessung mittels der einer Regeleinrichtung einer Lasereinrichtung zur Laserbeaufschlagung des Kontaktelements zugeordneten Sensoreinrichtung, wobei die Regeleinrichtung in Abhängigkeit von einem auf Basis eines Sensorausgangssignals ermittelten Temperaturgradienten den Betrieb der Lasereinrichtung regelt.

Nachfolgend wird eine bevorzugte Ausführungsform der Erfindung mit Bezug auf die beigefügten Zeichnungen näher erläutert.

Es zeigen:
- **Fig. 1**: einen Kontaktkopf zur Platzierung und Kontaktierung eines Prüfkontakts auf einem Kontaktträger in einer ersten Ausführungsform;
- **Fig. 2**: die Platzierung eines Prüfkontakts auf einem Kontaktträger zur Herstellung einer Prüfkontaktanordnung;
- **Fig. 3**: den Kontaktkopf mit einem in einer Prüfkontakthalteeinrichtung aufgenommenen Prüfkontakt während der Kontaktierung des Prüfkontakts mit einer Kontaktfläche des Kontaktträgers;
- **Fig. 4**: den Kontaktierungsvorgang zwischen dem Prüfkontakt und einem auf der Kontaktfläche des Kontaktträgers angeordneten Verbindungsmaterialdepot in einer ersten Kontaktierungsphase;
- **Fig. 5**: den Kontaktierungsvorgang in einer zweiten Kontaktierungsphase;
- **Fig. 6**: den Kontaktierungsvorgang in einer dritten Kontaktierungsphase;
- **Fig. 7**: eine weitere Ausführungsform eines Kontaktkopfs zur Platzierung und Kontaktierung eines Prüfkontakts.

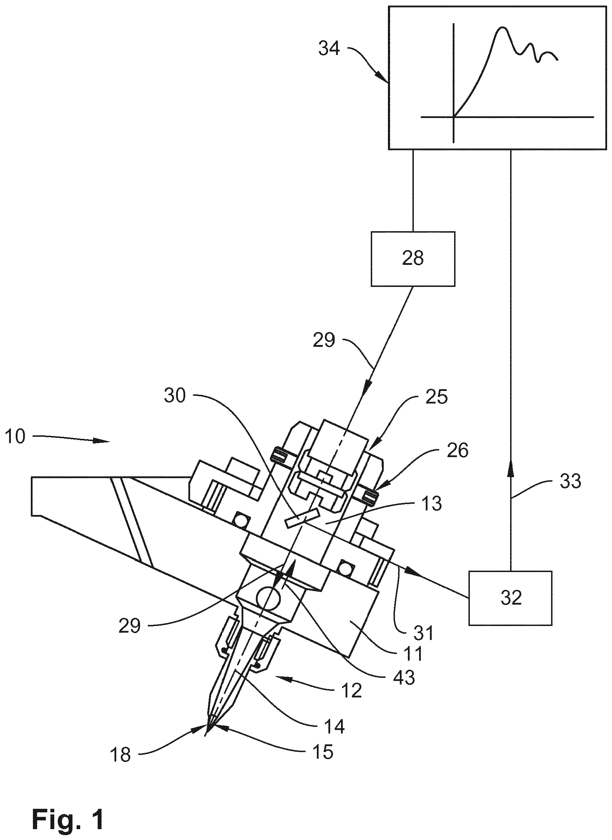

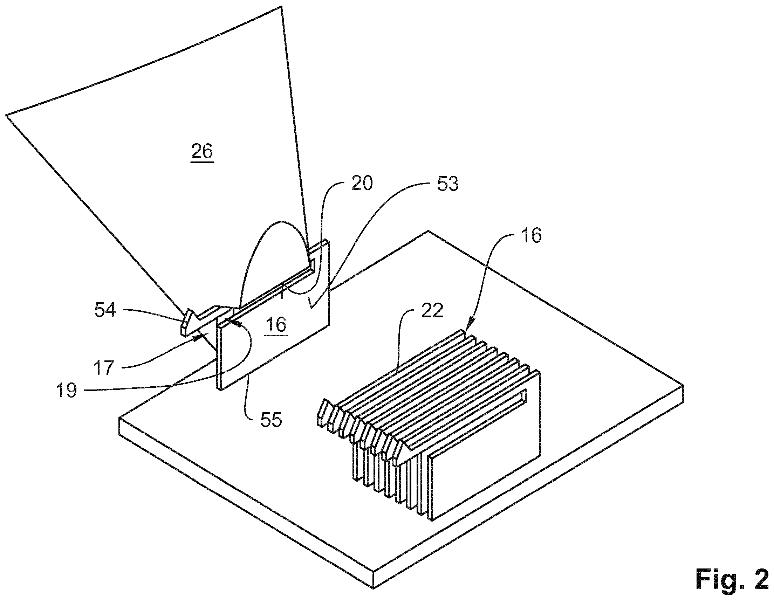

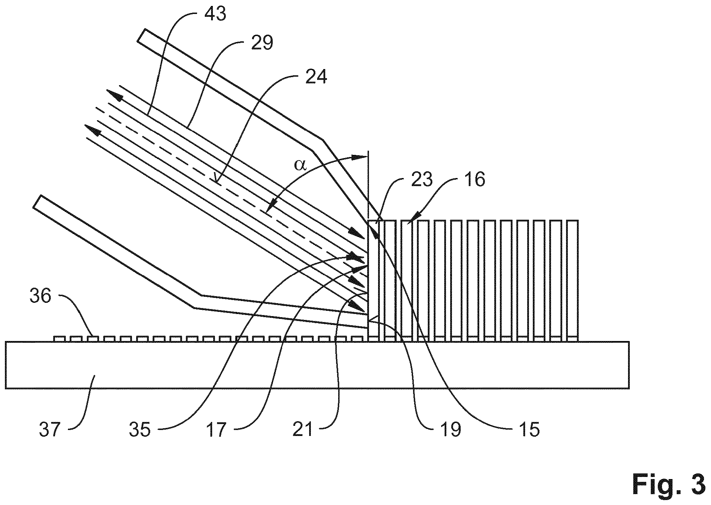

**Fig. 1** zeigt einen Kontaktkopf 10, der ein an einer Kontaktkopfbasis 11 des Kontaktkopfs 10 befestigtes Kontaktmundstück 12 aufweist, das einen in axialer Verlängerung eines Strahlenkanals 13 des Kontaktkopfs 10 angeordneten Strahlenkanal 14 aufweist, der an einem freien Ende des Kontaktmundstücks 12 in einer Kontaktelementhalteeinrichtung 15 endet, die, wie insbesondere aus den **Figuren 2** und **3** ersichtlich, zur Aufnahme eines Kontaktelements 16 dient.

Wie aus einer Zusammenschau der **Figuren 2** und **3** deutlich wird, ermöglicht die Kontaktelementhalteeinrichtung 15 eine positionierende Aufnahme des Kontaktelements 16 in einem Öffnungsquerschnitt 17, einer in der Kontaktelementhalteeinrichtung 15 ausgebildeten Kanalmündung 18 des Strahlenkanals 14. Zur Erzeugung einer Haltekraft, mit der das Kontaktelement 16 in der Kontaktelementhalteeinrichtung 15 gehalten wird, erfolgt eine Unterdruckbeaufschlagung des in der Kontaktelementhalteeinrichtung 15 aufgenommenen Kontaktelements 16 über die Strahlenkanäle 13 und 14.

Zur positionierenden Aufnahme des Kontaktelements 16 weist die Kontaktelementhalteeinrichtung 15 zwei Positionierungsflächen 19, 20 auf, die, wie insbesondere aus einer Zusammenschau der **Fig. 2** **und** **3** ersichtlich, eine Anlage des Kontaktelements 16 mit einer Rückseite 21 gegen die Positionierungsfläche 19 und einem oberen, hier durch einen Kontaktausleger 22 des Kontaktelements 16 ausgebildeten Oberrand 23 gegen die Positionierungsfläche 20 ermöglichen. Dabei sind die Positionierungsflächen 19, 20 so an der Kanalmündung 18 angeordnet, so dass, wie in **Fig. 3** dargestellt, die Rückseite 21 unter einem Winkel α auf einer Kanalachse 24 angeordnet ist.

Wie **Fig. 1** zeigt, ist am oberen Ende des im Kontaktkopf 10 ausgebildeten Strahlenkanals 13 eine Strahlungseinkopplungseinrichtung 25 vorgesehen, die eine Fokussierungseinrichtung 26 und eine Zentrierungseinrichtung 27 aufweist, welche eine Fokussierung und Zentrierung einer von einer oberhalb des Kontaktkopfs 10 angeordneten Lasereinrichtung 28 emittierten Laserstrahlung 29 auf die Rückseite 21 eines in der Kontaktelementhalteeinrichtung 15 aufgenommenen Kontaktelements 16 ermöglichen.

Wie ferner **Fig. 1** zeigt, ist im Strahlenkanal 13 des Kontaktkopfs 10 ein Strahlteiler 30 vorgesehen, der eine Strahlungsauskopplung eines von der Rückseite 21 des Kontaktelements 16 reflektierten Infrarot-Strahlungsanteils 31 aus einer Reflektionsstrahlung 43 ermöglicht. Der IR-Strahlungsanteil 31 wird einer Sensoreinrichtung 32 zugeführt, mit der eine Messung der Temperatur T des Prüfkontakts 16 infolge einer Beaufschlagung des Kontaktelements 16 mit der Laserstrahlung 29 erfolgt, und die ein der einer mittels der Sensoreinrichtung 32 gemessenen Temperatur des Kontaktelements 16 entsprechendes Sensorausgangssignal 33 einer Regeleinrichtung 34 zuführt, die aufgrund des Sensorausgangssignals 33 einen Temperaturgradienten der Temperatur des Kontaktelements 16 ermittelt und in Abhängigkeit von dem Temperaturgradienten eine Ansteuerung der Lasereinrichtung ausführt, derart, dass die Leistung und/oder die Pulsdauer oder Pulsfrequenz der von der Lasereinrichtung 28 emittierten Laserstrahlung 29 beeinflusst wird.

Wie anhand der Darstellung in **Fig. 3** deutlich wird, ist durch die Aufnahme des Kontaktelements 16 in der Kontaktelementhalteeinrichtung 15 auf der Rückseite 21 des Kontaktelements 16 eine Absorptionsfläche 35 definiert, die mit der Laserstrahlung 29 beaufschlagt wird. Für die Messung der Temperatur des Prüfkontakts 16 mittels der Sensoreinrichtung 32, die, wie in **Fig. 1** dargestellt, über den Strahlteiler 30 mit dem IR-Strahlungsanteil 31 beaufschlagt wird, bildet die Absorptionsfläche 35 gleichzeitig die maßgebliche Reflektionsfläche aus.

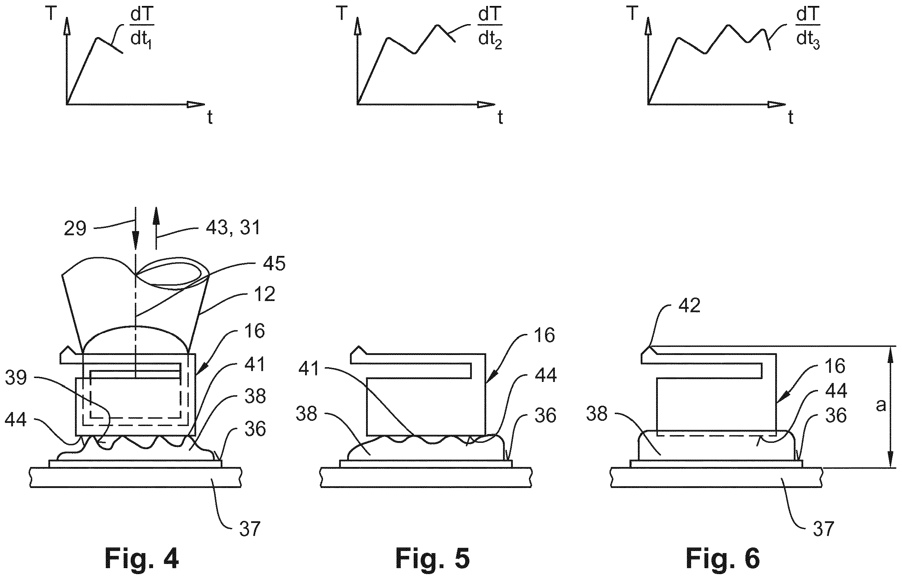

In den **Figuren 4** bis **6** ist ein nachfolgend einer Platzierung eines Kontaktelements 16 auf einer Kontaktfläche 36 eines Kontaktträgers 37, bei der ein unterer Kontaktrand 44 des Kontaktelements 16 zur Anlage gegen eine von einem Verbindungsmaterialdepot 38 gebildeten Kontaktoberfläche 39 gebracht wird, erfolgender Kontaktierungsvorgang schematisch dargestellt.

In einer ersten Kontaktierungsphase liegt das Kontaktelement 16 mit seinem unteren Kontaktrand 44 gegen die von Oberflächenrauigkeiten noch zerklüftet ausgebildete Kontaktoberfläche 39 des Verbindungsmaterialdepots 38 an, wobei eine Wärmeübergangsfläche lediglich im Bereich der Oberflächenspitzen 41 der Kontaktoberfläche 39 ausgebildet ist. Ausgehend von diesem noch starren Zustand des Verbindungsmaterialdepots 38 erfolgt eine Beaufschlagung der Rückseite 21 des Kontaktelements 16 mit Laserstrahlung 29.

Wie in **Fig. 4** dargestellt, ergibt sich aufgrund der zunächst sehr kleinen Wärmeübergangsfläche zwischen dem Kontaktelement 16 und dem Verbindungsmaterial 38 ausgehend von einer durch die Laserstrahlung 29 im Kontaktelement 16 erzeugten Temperatur T ein relativ geringer Wärmeabfluss aus dem Kontaktelement 16 in das Verbindungsmaterialdepot 38 und somit ein entsprechend kleiner Temperaturabfall oder Temperaturgradient dT/dt, in der die Temperatur T des Kontaktelements 16, die von der Sensoreinrichtung 32 (**Fig. 1**) mittels des von der Rückseite 21 reflektierten IR-Strahlungsanteils 31 gemessen wird.

Wie **Fig. 5** zeigt, erfolgt in einer zweiten Kontaktierungsphase durch die Beaufschlagung mit Laserstrahlung 29 unter gleichzeitiger Einwirkung eines Kontaktdrucks des Kontaktmundstücks 12 gegen die Kontaktoberfläche 39 längs einer Zustellachse 45, auf der der Kontaktkopf 10 gegen den Kontaktträger 37 verfahren wird, ein zumindest partielles Aufschmelzen des Verbindungsmaterialdepots 38 entsprechend der in **Fig. 5** dargestellten zweiten Kontaktierungsphase eine teilweise Einebnung der Oberflächenspitzen 41 mit einer entsprechenden Vergrößerung der Wärmeübergangsfläche zwischen dem Kontaktrand 44 des Kontaktelements 16 und dem Verbindungsmaterialdepot 38.

Wie der Temperaturverlauf der Temperatur T des Kontaktelements 16 in **Fig. 5** zeigt, erfolgt zum Ausgleich des Temperaturgradienten eine Erhöhung der Temperatur T durch eine entsprechende Ansteuerung der Lasereinrichtung 28, derart, dass die Leistung erhöht wird oder bei einer im Pulsbetrieb betriebenen Lasereinrichtung eine weitere Pulsung bzw. eine Erhöhung der Pulsfrequenz erfolgt. Infolge des partiellen Aufschmelzens des Verbindungsmaterialdepots 38 ergibt sich eine Vergrößerung der Wärmeübergangsfläche, so dass ein verstärkter Wärmeabfluss entsprechend der Ausbildung eines größeren Temperaturgradienten dT/dt₂ erfolgt.

Der damit verbundene erneute Temperaturabfall in der Temperatur T des Kontaktelements 16 wird, wie in **Fig. 6** dargestellt, durch eine entsprechende Laseransteuerung und der daraus resultierenden Erhöhung der Temperatur T ausgeglichen, wobei als Folge eines weiteren partiellen Aufschmelzens des Verbindungsmaterialdepots und einer sich daraus ergebenden Einbettung des Kontaktrands 44 in das Verbindungsmaterialdepot 38 sich zunächst ein noch höherer Temperaturgradient dT/dt₃ ausbildet, so dass dieser Temperaturgradient als Parameter für den in **Fig. 6** dargestellten Zustand der stoffschlüssigen Verbindung zwischen den Verbindungsmaterialdepot 38 und dem Kontaktelement 16 dient, so dass nun nachfolgend durch eine Veränderung des Abstands des Kontaktmundstücks 12 gegenüber dem Kontaktträger 37 durch eine entsprechende Bewegung des Kontaktkopfs 10 auf der Zustellachse 45 ein Kontaktabstand a einer am Kontaktausleger des Kontaktelements 16 ausgebildeten Kontaktspitze 42 gegenüber dem Kontaktträger 37 eingestellt werden kann. Nach Einstellung des Kotaktabstands a erfolgt eine Abschaltung der Laserbeaufschlagung, so dass die durch den Kontaktierungsvorgang erreichte Relativpositionierung des Kontaktelements 16 auf dem Kontaktträger 37 eingefroren wird, und das Kontaktelement 16 aus der Kontaktelementhalteeinrichtung 15 durch Abschaltung einer Unterdruckbeaufschlagung des Kontaktelements 16 freigegeben werden kann.

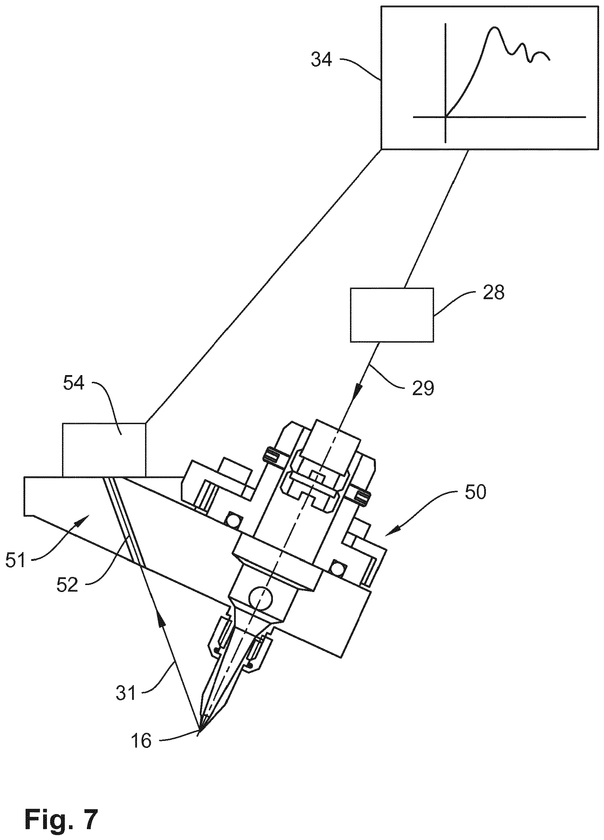

**Fig. 7** zeigt eine weitere mögliche Ausführungsform eines Kontaktkopfs 50, der im Wesentlichen übereinstimmend mit dem Kontaktkopf 10 ausgebildet ist, abgesehen davon, dass die Messung der Temperatur T eines in der Kontaktelementhalteeinrichtung 15 aufgenommenen Kontaktelements 16 mittels eines auf die Kontaktelementhalteeinrichtung 15 ausgerichteten, in einer Kontaktkopfbasis 51 ausgebildeten weiteren Strahlenkanals 52 erfolgt, derart, dass ein von einer Vorderseite 53 eines in der Kontaktelementhalteeinrichtung 15 aufgenommenen Kontaktelements 16 reflektierter Infrarot-Strahlungsanteil 31 durch den Strahlenkanal 52 einer Sensoreinrichtung 54 zugeführt wird.

## Patentansprüche

1. Verfahren zur Platzierung und Kontaktierung eines insbesondere als Prüfkontakt einer Prüfkontaktanordnung ausgebildeten Kontaktelements (16), bei dem ein mit einer Kontaktelementhalteeinrichtung (15) versehener Kontaktkopf (10, 50) mit dem in der Kontaktelementhalteeinrichtung aufgenommenen Kontaktelement zur Ausbilddung einer Wärmeübergangsfläche zwischen dem Kontaktelement und einem auf einer Kontaktfläche (36) eines Kontaktträgers (37) angeordneten Verbindungsmaterialdepot (38) in Richtung einer Zustellachse (45) gegen eine Kontaktoberfläche (39) des Verbindungsmaterialdepots platziert wird, und zur Erzielung eines zumindest partiellen Aufschmelzens des Verbindungsmaterialdepots und zur Herstellung einer stoffschlüssigen Verbindung zwischen dem Kontaktelement und dem Verbindungsmaterialdepot die Einbringung von Wärmeenergie in das Verbindungsmaterialdepot mittels einer Beaufschlagung des Kontaktelements mit Wärmeenergie erfolgt,
**dadurch gekennzeichnet,**
**dass** während der Beaufschlagung die Temperatur T des Kontaktelements (16) gemessen wird und die Dauer der Beaufschlagung in Abhängigkeit von einem ermittelten Temperaturgradienten dT/dt der Temperatur T des Kontaktelements (16) definiert wird, wobei die Temperaturmessung mittels der einer Regeleinrichtung (34) einer Lasereinrichtung (28) zur Laserbeaufschlagung des Kontaktelements (16) zugeordneten Sensoreinrichtung (32, 54) erfolgt, und wobei die Regeleinrichtung in Abhängigkeit von einem auf Basis eines Sensorausgangssignals ermittelten Temperaturgradienten dT/dt den Betrieb der Lasereinrichtung regelt.

2. Verfahren nach Anspruch 1,
**dadurch gekennzeichnet,**
**dass** die Beaufschlagung des Kontaktelements (16) mit Wärmeenergie in Abhängigkeit vom Betrag oder dem Verlauf des Temperaturgradienten dT/dt erfolgt.

3. Verfahren nach Anspruch 1 oder 2,
**dadurch gekennzeichnet,**
**dass** die Beaufschlagung des Kontaktelements (16) mit Wärmeenergie mittels Laserstrahlung (29) erfolgt.

4. Verfahren nach einem der vorangehenden Ansprüche,
**dadurch gekennzeichnet,**
**dass** nach Erreichen eines definierten Temperaturgradienten dT/dt und vor Beendigung der Beaufschlagung des Kontaktelements (16) mit Wärmeenergie eine Änderung der Relativposition des Kontaktkopfs gegenüber dem Kontaktträger (37) zur Einstellung einer definierten Relativposition des stoffschlüssig mit dem Verbindungsmaterialdepot (38) verbundenen Kontaktelements auf dem Kontaktträger erfolgt.

5. Verfahren nach Anspruch 4,
**dadurch gekennzeichnet,**
**dass** zur Einstellung einer definierten Relativposition des Kontaktelements (16) auf dem Kontaktträger (37) eine Verstellung des Kontaktkopfs (10, 50) auf der Zustellachse (45) erfolgt.

6. Verfahren nach Anspruch 5,
**dadurch gekennzeichnet,**
**dass** nach erfolgter Positionierung und einer der Beendigung der Beaufschlagung des Kontaktelements (16) mit Wärmeenergie nachfolgenden Abkühlphase des Kontaktelements eine Freigabe des Kontaktelements aus der Prüfkontakthalteeinrichtung (15) erfolgt.

7. Verfahren nach einem der vorangehenden Ansprüche,
**dadurch gekennzeichnet,**
**dass** die Messung der Temperatur des Kontaktelements (16) mittels der Messung der von einer Referenzoberfläche des Kontaktelements reflektierten Wärmestrahlung erfolgt.

8. Verfahren nach Anspruch 7,
**dadurch gekennzeichnet,**
**dass** die Referenzoberfläche mit einer Absorptionsoberfläche (35) des Kontaktelements (16) übereinstimmt, die mit der Wärmeenergie beaufschlagt wird.

9. Verfahren nach Anspruch 7,
**dadurch gekennzeichnet,**
**dass** die Referenzoberfläche durch eine der Absorptionsoberfläche (35) gegenüberliegende Oberfläche des Kontaktelements (16) gebildet ist.

10. Verfahren nach einem der vorangehenden Ansprüche,
**dadurch gekennzeichnet,**
**dass** die Temperaturmessung mittels eines in einem Strahlengang (13) zur Beaufschlagung der Absorptionsoberfläche (35) mit Laserstrahlung (29) angeordneten Strahlteilers (30) erfolgt, mittels dem eine Auskopplung eines Infrarot-Strahlenanteils (31) aus der von der Absorptionsoberfläche reflektierten Strahlung zur Beaufschlagung einer Sensoreinrichtung (32) erfolgt.

11. Verfahren nach Anspruch 8,
**dadurch gekennzeichnet,**
**dass** die Temperaturmessung mittels eines auf die Referenzoberfläche ausgerichteten Strahlenkanals (52) erfolgt, der auf eine Sensoreinrichtung (54) ausgerichtet ist.

## Claims

1. A method for placing and contacting a contact element (16) formed in particular as a test contact of a test contact arrangement, wherein in said method, for forming a heat transfer surface, a contact head (10, 50) provided with a contact element holding device (15), with the contact element received in the contact element holding device, is placed between the contact element and a connecting material deposit (38) arranged on a contact surface (36) of a contact carrier (37) in the direction of a feeding axis (45) against a contact surface (39) of the connecting material deposit, and, for realizing an at least partial fusing of the connecting material deposit and for producing a materially bonded connection between the contact element and the connecting material deposit, thermal energy is introduced into the connecting material deposit by means of treating the contact element with thermal energy, **characterized in that**
the temperature T of the contact element (16) is measured while the contact element is being treated and the duration of the treatment is defined as a function of a determined temperature gradient dT/dt of the temperature T of the contact element (16), wherein measuring of the temperature is realized by means of the sensor device (32, 54) being allocated to a controlling device (34) of a laser device (28) for laser treatment of the contact element (16), the controlling device controlling the operation of the laser device as a function of a temperature gradient dT/dt determined on the basis of a sensor output signal.

2. The method according to claim 1,
**characterized in that**
treating the contact element (16) with thermal energy is realized as a function of the amount or the progression of the temperature gradient dT/dt.

3. The method according to claim 1 or 2,
**characterized in that**
treating the contact element (16) with thermal energy is realized by means of laser radiation (29).

4. The method according to any one of the preceding claims,
**characterized in that**
after reaching a defined temperature gradient dT/dt and before terminating the treatment of the contact element (16) with thermal energy, a change in the relative position of the contact head with respect to the contact carrier (37) is realized for setting a defined relative position of the contact element materially bonded to the connecting material deposit (38) on the contact carrier.

5. The method according to claim 4,
**characterized in that**
the contact head (10, 50) is displaced on the feeding axis (45) for setting a defined relative position of the contact element (16) on the contact carrier (37).

6. The method according to claim 5,
**characterized in that**
after positioning the contact element (16) and after a cooling phase following the termination of the treatment of the contact element (16) with thermal energy, said contact element is released from the test contact holding device (15).

7. The method according to any one of the preceding claims, **characterized in that**
measuring the temperature of the contact element (16) is carried out by means of measuring the thermal radiation reflected by a reference surface of the contact element.

8. The method according to claim 7,
**characterized in that**
the reference surface corresponds to an absorption surface (35) of the contact element (16), said absorption surface (35) being treated with thermal energy.

9. The method according to claim 7,
**characterized in that**
the reference surface is formed by a surface of the contact element (16) opposite to the absorption surface (35).

10. The method according to any one of the preceding claims,
**characterized in that**
measuring the temperature is realized by means of a beam splitter (30) arranged in a beam path (13) for treating the absorption surface (35) with laser radiation (29), an offtake of an infrared beam portion (31) from the radiation reflected by the absorption surface being realized by means of said beam splitter (30) for application of said infrared beam portion (31) to a sensor device (32).

11. The method according to claim 8,
**characterized in that**
measuring the temperature is realized by means of a beam channel (52) directed to the reference surface, said beam channel being directed to a sensor device (54).

## Revendications

1. Procédé pour le placement et la mise en contact d'un élément de contact (16) formé notamment comme contact d'essai d'un agencement de contact d'essai, dans lequel pour ledit procédé, pour la formation d'une surface de transfert de chaleur, une tête de contact (10, 50) pourvue d'un dispositif de retenue(15) d'un élément de contact (16), avec l'élément de contact reçu dans le dispositif de retenue d'un élément de contact, est positionnée entre l'élément de contact et un dépôt (38) de matériau de connexion disposé sur une surface de contact (36) d'un support de contact (37) dans le sens d'un axe d'avance (45) contre une surface de contact (39) du dépôt de matériau de connexion, et, pour la réalisation d'une fusion au moins en partie du dépôt de matériau de connexion et pour la production d'une connexion par liaison de matière entre l'élément de contact et le dépôt de matériau de connexion, de l'énergie thermique est introduite dans le dépôt de matériau de connexion au moyen d'un traitement de l'élément de contact avec de l'énergie thermique,
**caractérisé en ce que**
la température T de l'élément de contact (16) est mesurée pendant que l'élément de contact est traité et la durée du traitement est définie en fonction d'un gradient de température dT/dt déterminé de la température T de l'élément de contact (16), dans lequel la température est mesurée au moyen du dispositif de capteur (32, 54) étant assigné à un dispositif de contrôle (34) d'un dispositif laser (28) pour le traitement au laser de l'élément de contact (16), le dispositif de contrôle contrôlant l'opération du dispositif laser en fonction d'un gradient de température dT/dt déterminé sur la base d'un signal de sortie de capteur.

2. Procédé selon la revendication 1,
**caractérisé en ce que**
l'élément de contact (16) est traité avec de l'énergie thermique en fonction de la valeur ou de la courbe du gradient de température dT/dt.

3. Procédé selon la revendication 1 ou la revendication 2,
**caractérisé en ce que**
l'élément de contact (16) est traité avec de l'énergie thermique au moyen du rayonnement laser (29).

4. Procédé selon l'une quelconque des revendications précédentes, **caractérisé en ce**
**qu'**après qu'un gradient de température dT/dt défini est atteint et avant que le traitement de l'élément de contact (16) avec de l'énergie thermique est terminé, la position relative de la tête de contact par rapport au support de contact (37) est changée pour l'ajustement d'une position relative définie de l'élément de contact relié par liaison de matière au dépôt (38) de matériau de connexion sur le support de contact.

5. Procédé selon la revendication 4,
**caractérisé en ce que**
la tête de contact (10, 50) est déplacée sur l'axe d'avance (45) pour l'ajustement d'une position relative définie de l'élément de contact (16) sur le support de contact (37).

6. Procédé selon la revendication 5,
**caractérisé en ce**
**qu'**après le positionnement de l'élément de contact (16) et après une phase de refroidissement suivant la terminaison du traitement de l'élément de contact (16) avec de l'énergie thermique, ledit élément de contact est libéré du dispositif de retenue (15) de contact d'essai (16).

7. Procédé selon l'une quelconque des revendications précédentes, **caractérisé en ce que**
la température de l'élément de contact (16) est mesurée au moyen de la mesure de la radiation thermique réfléchie par une surface de référence de l'élément de contact.

8. Procédé selon la revendication 7,
**caractérisé en ce que**
la surface de référence correspond à une surface d'absorption (35) de l'élément de contact (16), ladite surface d'absorption (35) étant traitée avec de l'énergie thermique.

9. Procédé selon la revendication 7,
**caractérisé en ce que**
la surface de référence est formée par une surface de l'élément de contact (16) vis-à-vis de la surface d'absorption (35).

10. Procédé selon l'une quelconque des revendications précédentes,
**caractérisé en ce que**
la température est mesurée au moyen d'un séparateur de faisceau (30) disposé dans un trajet de faisceau (13) pour le traitement de la surface d'absorption (35) au rayonnement laser (29), un prélèvement d'une partie de faisceau infrarouge (31) à partir du rayonnement réfléchi par la surface d'absorption étant réalisé au moyen dudit séparateur de faisceau (30) pour l'application de ladite partie de faisceau infrarouge (31) à un dispositif de capteur (32).

11. Procédé selon la revendication 8,
**caractérisé en ce que**
la température est mesurée au moyen d'un canal de faisceau (52) orienté vers la surface de référence, ledit canal de faisceau (52) étant orienté vers un dispositif de capteur (54).
